# EUROPEAN PATENT SPECIFICATION

(11) **EP 2 216 815 B1**
(45) Date of publication and mention of the grant of the patent: **02.04.2014**
(21) Application number: 09001631.2
(22) Date of filing: 05.02.2009
(51) Int. Cl.: H01L 27/06, H01L 27/144

(54) **Integrated circuit comprising PIN diodes**
Integrierte Schaltung mit PIN-Dioden
Circuit intégré comportant des diodes PIN

(43) Date of publication of application: 11.08.2010
(73) Proprietor: ams AG, 8141 Unterpremstätten (AT)
(72) Inventor: Jonak-Auer, Ingrid, Dr., 8043 Graz (AT); Vescoli, Verena, Dr., 8010 Graz (AT); Teva, Jordi, Dr., 8020 Graz (AT)
(74) Representative: Epping - Hermann - Fischer

(56) References cited:
- WO-A-03/081813
- WO-A-2006/048001
- WO-A-2008/065441
- WO-A-2008/129433
- JP-A- 3 203 266
- JP-A- 2003 224 252
- JP-A- 2005 101 272
- US-A- 4 990 990
- US-A- 5 055 894
- US-A- 5 886 374
- US-A1- 2007 085 117
- US-A1- 2007 120 131

## Description

The present invention relates to PIN diodes that are monolithically integrated and can be produced in a conventional manufacturing process of integrated circuits comprising, for instance, bipolar, CMOS or BiCMOS devices.

PIN diodes comprise a semiconductor region of very low electric conductivity, called intrinsic, which is arranged between a p-doped region and an n-doped region. An intrinsic conductivity is generated by impurities of the semiconductor material that are present without an implantation or a diffusion of a dopant. The large volume of the depletion region of a PIN diode causes a very effective photogeneration of electron-hole pairs, rendering high sensitivity and fast response due to electron-hole drift. The substrate may be provided with a low-doped epilayer, in which the intrinsically conducting region of the PIN diode is located.

Monolithically integrated PIN diodes are directly connected to integrated circuits, which may comprise a CMOS logic, for example. Monolithically integrated PIN diodes are therefore suitable for a larger bandwidth, compared with individual diodes. Important applications of CMOS integrated photodetectors are imaging, especially CMOS cameras, optical storage systems and optical interconnect technologies. CMOS integrated photodetectors respond to a broad range of wavelengths, including visible and near infrared light.

US 2007/0187795 A1 discloses an integrated circuit comprising a p-doped substrate with an epitaxial n-layer, a PIN photodiode located above a buried n⁺-layer and a weakly p-doped circuit region located above a buried p⁺-layer. The intrinsically doped region of the PIN photodiode is laterally completely surrounded by an n-doped connection region. A p⁺-doped region forms the anode of the PIN photodiode. A plurality of circuit components, like an npn transistor, a capacitor, an n-channel transistor, and a p-channel transistor, are arranged in the circuit region.

WO 2006/048001 A1 discloses a CMOS integrated circuit in an epitaxial p-layer on a p⁺-substrate. CMOS devices are located in n-wells and p-wells, which are formed in the epitaxial p-layer. An n⁺-doped drain region forms the cathode of a PIN photodiode.

WO 2008/065441 A1 discloses a semiconductor device comprising a substrate with an intrinsically conductive epitaxial layer, a PIN diode, an isolating deep n well, a p well arranged in the n well, and a low voltage device arranged in the p well.

WO 2008/129433 A2 discloses a photodiode device comprising an isolation trench.

US 5 886 374 A discloses an optically sensitive device comprising a pin diode and an isolation region that is formed by a trench.

US 4 990 990 A discloses a waveguide-photodiode-FET combination including a parting region, which may be formed by an etched-out trench.

US 5 055 894 A discloses an LED/PIN photodetector array, in which the PIN diodes and the LEDs are separated by an isolation etch.

US 2007/0085117 A1 discloses a photodetector array comprising doped isolation regions.

JP03203266 discloses a lateral pin photodiode integrated with a CMOS circuit.

It is an object of this invention to present an improved monolithically integrated circuit comprising a PIN photodiode, which can be produced within a standard CMOS process, and an effective production method.

This object is achieved with the integrated circuit comprising a PIN diode according to claim 1. Variants and embodiments derive from the dependent claims.

The invention makes use of a semiconductor region - designated by "I" region in the following - which has an intrinsic conductivity or a weak concentration of doping atoms generating a low electric conductivity of a first type, which can be especially p-type conductivity. The "I" region is located at a surface of a semiconductor substrate or wafer and may be formed by a weakly doped epitaxially grown layer of the first type of conductivity. In the "I" region a doped region of the first type of conductivity - designated by PSUB well in the following - is provided for components of an integrated circuit, especially for logic components like CMOS devices. The concentration of doping atoms in the PSUB well is adapted to the integration of the circuit components and can preferably be comparable to the doping of a semiconductor substrate conventionally used for the integration of CMOS devices. The "I" region provides the intrinsically doped region of a PIN diode, whereas the further components of the integrated circuit are located in the PSUB well. The arrangement of the PSUB well in the "I" region enables an optimization of both the PIN diode and the further components of the integrated circuit. This is achieved using only one additional mask - designated by PSUB mask in the following - for the implantation of the PSUB well. The PSUB well can thus be provided with a lateral and vertical doping profile which corresponds to the prime wafer doping profile conventionally used in a CMOS process, and full functionality of the CMOS logic can be guaranteed.

In the following a detailed description of examples of the present invention and the advantages thereof is given, reference being made to the accompanying drawings.
Figure 1 shows a cross-section of an embodiment of the integrated circuit comprising a PIN diode.
Figure 2 shows a cross-section of a further embodiment of the integrated circuit comprising a PIN diode.
Figure 3 shows a flow chart of a process of production.

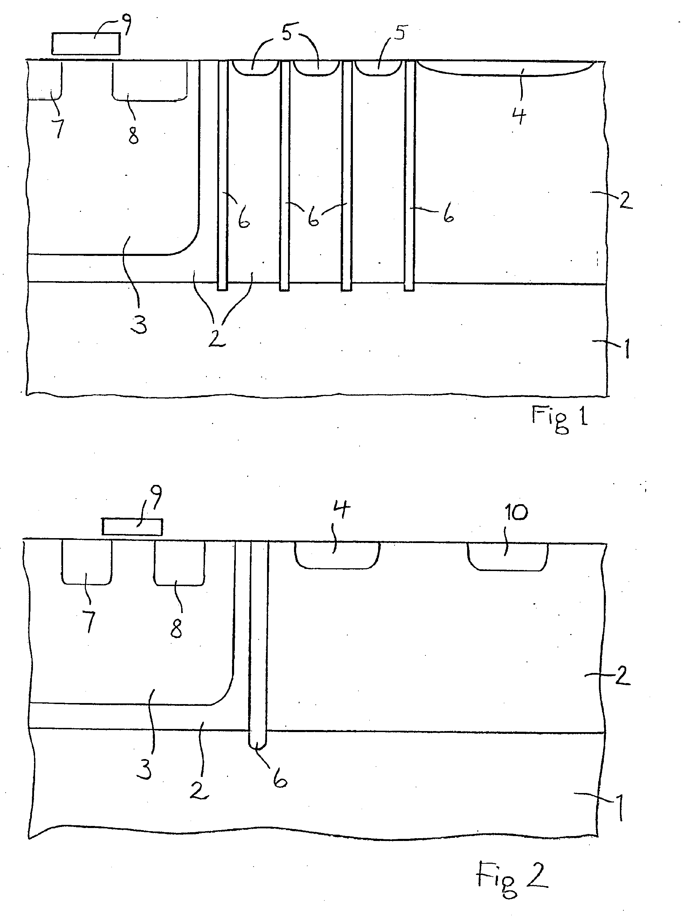

Figure 1 shows a cross-section of an embodiment comprising a semiconductor, especially silicon, substrate 1, which can have p⁺-type conductivity and a resistivity of typically about 0.002 to 0.02 Ω cm, for example. At a surface of the substrate 1, there is an "I" region 2, which has a low conductivity of the first type, a p-type conductivity in this example, either from being intrinsically conductive or from being weakly doped. In this embodiment the "I" region 2 is formed by an epitaxial layer of low doping concentration. The application of an epitaxially grown layer has the advantage that the thickness and the doping concentration of the "I" region 2 can be better adapted to the requirements of the photodetector. The thickness of the epitaxial layer can vary typically from 10 µm to 25 µm, for example. The larger the thickness of the epitaxial layer, the larger is the wavelength of maximal sensitivity of the photodiode. A PSUB well 3 is embedded in the "I" region 2 and contains further devices, for example components of a CMOS logic circuit. The PSUB well 3 has a conductivity of the first type, which is p-type conductivity in this example, like a conventional semiconductor wafer used for CMOS circuits. The PSUB well 3 thus allows an optimal integration of the further devices of the circuit, here represented by a transistor structure comprising a source region 7, a drain region 8 and a gate electrode 9.

Each PIN diode is formed by the substrate 1, a portion of the "I" region 2, and a doped region 4, 5 of a second type of conductivity - designated by PIN region in the following. The sign of the second type of conductivity, which is n-type conductivity in this embodiment, is opposite to the sign of the first type of conductivity. An electric connection of the substrate 1 to the integrated circuit can be provided by further doped regions that are implanted within the "I" region 2 or by trenches that are filled with electrically conductive material. The PIN regions 4, 5 can be formed by one or more implantation steps which are already available within the CMOS process. PIN regions of n-type conductivity can be formed together with implantations of N-wells or n-type source/drain regions, for example. Figure 1 shows integrated PIN diodes of different sizes, a larger PIN region 4 of a single PIN diode and a plurality of smaller PIN regions 5 of an array of PIN diodes. The PIN diodes are separated from one another and from the PSUB well 3 by deep isolation trenches 6, so that the area occupied by the integrated circuit including the PIN diodes can be kept small.

The monolithically integrated PIN diodes can be arranged vertically, as in the described embodiment, or laterally. If a lateral arrangement is desired, additional PIN regions of the first type of conductivity are implanted in the "I" region at a distance from the PIN regions already described. Thus PIN regions of opposite types of conductivity which are separated by portions of the "I" region 2 can be formed at the surface of the device, especially at the surface of an epitaxial layer forming the "I" region 2, and it is not necessary to use the substrate 1 as one of the doped regions of the PIN diode.

Figure 2 shows a cross-section of a further embodiment comprising a lateral PIN diode having a PIN region 4 of the second type of conductivity and a further PIN region 10 of the first type of conductivity. The PIN region 4 and the further PIN region 10 are separated by an area of the "I" region 2, which can be formed by a low-doped epitaxial layer on the substrate 1. A deep isolation trench 6 separates the PIN diode from the PSUB well 3. The PSUB well 3 is doped in such a manner that an optimal integration of further devices of the circuit is possible, here again indicated by a transistor structure comprising a source region 7, a drain region 8, and a gate electrode 9. The integrated circuit of this embodiment can also comprise a plurality of PIN regions 5 of the second type of conductivity as in the embodiment of figure 1 and a plurality of further PIN regions 10 of the first type of conductivity, the plurality of further PIN regions 10, the "I" region 2 and the plurality of PIN regions 5 of the second type of conductivity forming a plurality of PIN diodes. Furthermore, both vertical and lateral PIN diodes can be monolithically integrated within the same integrated circuit, for instance by combining the PIN diodes of the embodiments according to figures 1 and 2.

Providing the PSUB well 3, the design rules and functionality of the integrated electronic circuit can be maintained, even if a conventional substrate is substituted with a substrate comprising a low-doped epitaxial layer. The PSUB well 3 can be implanted in such a manner that it perfectly reflects the conditions of the standard start material used in CMOS technology. Conventional N-wells and P-wells can be implanted in the PSUB well 3. A conventional wiring formed of structured metalization layers or conductor tracks embedded in intermetal dielectric can be arranged on the surface of the integrated circuit device. The CMOS circuitry can thus be realized in the usual way, the PSUB well 3 here substituting a conventional semiconductor substrate or wafer commonly used in CMOS processes. A monolithically integrated PIN diode can thus be realized with only slight modifications of the production process, leaving the rest of the circuitry essentially unchanged.

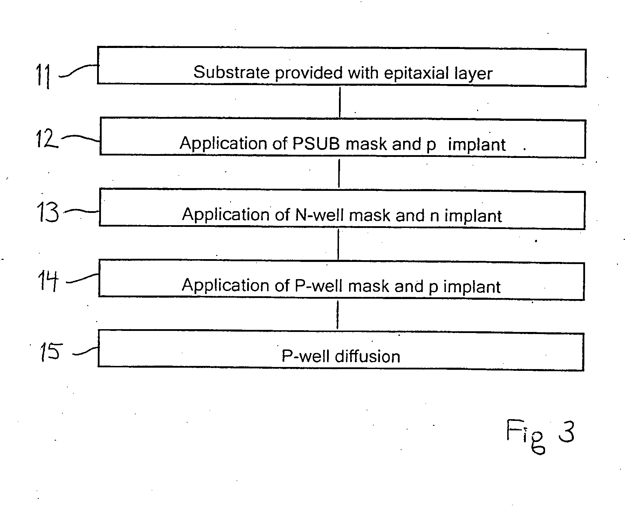

Figure 3 shows a flow chart of the first steps of a CMOS process that is especially adapted to the production of an integrated circuit according to the invention. A substrate is provided with an epitaxial layer of low doping concentration, step 11. The application of the PSUB mask and the p-implantation of the PSUB well, step 12, is a new process step according to the invention. The steps 13 and 14 relate to the implantations of N-wells and P-wells and can be performed in different order or be repeated according to the design of the integrated circuit. The P-well diffusion 15 is preferably effected by a thermal step.

It is a major advantage of the invention that the modularity of the CMOS process is not changed by the integration of the PIN diodes. Very sensitive high-speed PIN photodiodes can be monolithically integrated with a conventional CMOS logic. It is possible to use readily available p⁺-substrates that are provided with a p⁻-epilayer. Only one additional PSUB mask is needed. The invention encompasses the integration of isolated logic devices as well as the integration of high-voltage CMOS devices.

The most important technical advantages of integrated PIN diodes, compared to conventional pn-junction diodes, are: high dynamical quantum efficiency, very quick transient response to changing light intensities due to wide space charge regions and therefore important contribution of drifting photogenerated electron-hole pairs, and high quantum efficiency in a very broad wavelength range (300 - 1000 nm).

### List of reference numerals

- 1: substrate
- 2: "I" region
- 3: PSUB well
- 4: PIN region of single photodiode
- 5: PIN region of array of photodiodes
- 6: isolation trench
- 7: source region
- 8: drain region
- 9: gate electrode
- 10: further PIN region
- 11: first process step
- 12: second process step
- 13: third process step
- 14: fourth process step
- 15: fifth process step

## Claims

1. Integrated circuit comprising a PIN diode, comprising:
- a semiconductor substrate (1) having a first type of conductivity,
- an "I" region (2) at a surface of the substrate, the "I" region having intrinsic conductivity or a low doping of the first type of conductivity,
- a PSUB well (3) of the first type of conductivity,
- a plurality of PIN regions (4, 5) of a second type of conductivity, opposite to the first type of conductivity, the PIN regions being adjacent to the "I" region,
- the substrate (1), the "I" region (2) and the plurality of PIN regions (4, 5) forming a plurality of PIN diodes,
- a plurality of further PIN regions (10) of the first type of conductivity,
- the plurality of further PIN regions, the "I" region (2) and the plurality of PIN regions of the second type of conductivity forming a plurality of PIN diodes,
- a deep isolation trench (6) separating the PIN diodes from the PSUB well (3),
- isolation trenches (6) separating the PIN diodes from one another, and
- further components of the integrated circuit arranged in the PSUB well.

2. Integrated circuit according to claim 1, wherein
the first type of conductivity is p-type conductivity and the second type of conductivity is n-type conductivity.

3. Integrated circuit according to one of claims 1 or 2,
wherein
the further components of the integrated circuit arranged in the PSUB well (3) are CMOS devices.

4. Integrated circuit according to one of claims 1 to 3, further comprising:
N-wells and P-wells implanted in the PSUB well (3).

## Patentansprüche

1. Integrierte Schaltung mit einer PIN-Diode, Folgendes umfassend:
- ein Halbleitersubstrat (1), das über einen ersten Leitfähigkeitstyp verfügt,
- eine "I"-2one (2) auf einer Fläche des Substrats, wobei die "I"-Zone über Eigenleitfähigkeit oder eine geringe Dotierung des ersten Leitfähigkeitstyps verfügt,
- eine PSUB-Wanne (3) des ersten Leitfähigkeitstyps,
- mehrere PIN-Zonen (4, 5) eines zweiten Leitfähigkeitstyps, der dem ersten Leitfähigkeitstyp entgegengesetzt ist, wobei die PIN-Zonen an die "I"-Zone angrenzen,
- wobei das Substrat (1), die "I"-Zone (2) und die mehreren PIN-Zonen (4, 5) mehrere PIN-Dioden bilden,
- mehrere weitere PIN-Zonen (10) des ersten Leitfähigkeitstyps,
- wobei die mehreren weiteren PIN-Zonen, die "I"-Zone (2) und die mehreren PIN-Zonen des zweiten Leitfähigkeitstyps mehrere PIN-Dioden bilden,
- einen tiefen Isolationsgaben (6), der die PIN-Dioden von der PSUB-Wanne (3) trennt,
- Isolationsgräben (6), welche die PIN-Dioden voneinander trennen, und
- weitere Komponenten der integrierten Schaltung, die in der PSUB-Wanne angeordnet sind.

2. Integrierte Schaltung nach Anspruch 1, wobei es sich bei dem ersten Leitfähigkeitstyp um Leitfähigkeit des p-Typs und bei dem zweiten Leitfähigkeitstyp um Leitfähigkeit des n-Typs handelt.

3. Integrierte Schaltung nach einem der Ansprüche 1 oder 2, wobei
es sich bei den weiteren Komponenten der integrierten Schaltung, die in der PSUB-Wanne (3) angeordnet sind, um CMOS-Bauelemente handelt.

4. Integrierte Schaltung nach einem der Ansprüche 1 bis 3, darüber hinaus aufweisend:
N-Wannen und P-Wannen, die in der PSUB-Wanne (3) implantiert sind.

## Revendications

1. Circuit intégré comprenant une diode PIN, comprenant :
- un substrat semiconducteur (1) ayant un premier type de conductivité,
- une région "1" (2) sur une surface du substrat, la région "I" ayant une conductivité intrinsèque ou un faible dopage du premier type de conductivité,
- un puits PSUB (3) du premier type de conductivité,
- une pluralité de régions PIN (4, 5) d'un deuxième type de conductivité, opposé au premier type de conductivité, les régions PIN étant adjacentes à la région "I",
- le substrat (1), la région "I" (2) et la pluralité de régions PIN (4, 5) formant une pluralité de diodes PIN,
- une pluralité de régions PIN supplémentaires (10) du premier type de conductivité,
- la pluralité de régions PIN supplémentaires, la région "I" (2) et la pluralité de régions PIN du deuxième type de conductivité formant une pluralité de diodes PIN,
- une tranchée d'isolation profonde (6) séparant les diodes PIN du puits PSUB (3),
- des tranchées d'isolation (6) séparant les diodes PIN les unes des autres, et
- des composants supplémentaires du circuit intégré disposés dans le puits PSUB.

2. Circuit intégré selon la revendication 1, dans lequel le premier type de conductivité est une conductivité de type p et le deuxième type de conductivité est une conductivité de type n.

3. Circuit intégré selon l'une des revendications 1 ou 2, dans lequel
les composants supplémentaires du circuit intégré disposés dans le puits PSUB (3) sont des dispositifs CMOS.

4. Circuit intégré selon l'une des revendications 1 à 3, comprenant en outre :
des puits N et des puits P implantés dans le puits PSUB (3).
